# EUROPEAN PATENT APPLICATION

(11) **EP 4 303 337 A1**
(43) Date of publication of application: **10.01.2024**
(21) Application number: 23182842.7
(22) Date of filing: 30.06.2023
(51) Int. Cl.: C23C 16/44, C23C 16/455, H01J 37/32

(54) **SEMICONDUCTOR PROCESSING APPARATUS FOR PROCESSING A PLURALITY OF SUBSTRATES WITH CROSS FLOW**

(30) Priority: 04.07.2022 US 202263358207 P
(71) Applicant: ASM IP Holding B.V., 1322 AP Almere (NL)
(72) Inventor: RAAIJMAKERS, Ivo, 1322 AP Almere (NL); OOSTERLAKEN, Theodorus G.M., 1322 AP Almere (NL)
(74) Representative: V.O.

(57) **Abstract**

A semiconductor processing apparatus for processing a plurality of substrates is provided. In a preferred embodiment, the apparatus comprises a reaction chamber. The reaction chamber comprises a reaction space for receiving a substrate boat constructed and arranged for holding the plurality of substrates. The rection chamber further comprise a gas distributor for providing gas into the reaction space and a gas exhaust for removing gas from the reaction space. The boat, the gas distributor and the gas exhaust are constructed and arranged to at least partially enclose the substrates in the boat and to form a gas flow path, in use, from the gas distributor to the gas exhaust, wherein the gas flow path is substantially being directed in between the substrates.

## Description

### FIELD OF INVENTION

The present disclosure relates to the field of equipment used in semiconductor industry for processing substrate. More specifically, it relates to a semiconductor processing apparatus for processing a plurality of substrates.

### BACKGROUND OF THE DISCLOSURE

Semiconductor processing apparatuses for processing plurality of substrates have become increasingly employed in semiconductor processing. This may be due to the increased number of chips to be produced per substrate while being able to process increased number of substrates per process run, thus, not only helping to improve the throughput of the process but also helping to improve the throughput of the whole manufacturing. In particular, vertical furnaces may further help to save up operational costs by reducing the foot print of the apparatus occupied in the available cleanroom space. Vertical furnaces may be used for deposition processes such as chemical vapor deposition (CVD), atomic layer deposition (ALD), as well as oxidation, diffusion and annealing.

Employment of vertical furnaces may also present variety of challenges in terms of the process performance. These may vary from tuning of deposition characteristics to cleaning. Provision and flow of precursor gas(es) in the reaction space within the process chamber may play a role on uniformity, step coverage, materials properties, that may depend on diffusion between the plurality of substrates. Gas injectors may act as a remedy to address this to some extent, however; they may pose challenges in terms of non-uniformity.

There is therefore, a need in the art for enabling improved flow in between the plurality of substrates.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present disclosure to provide semiconductor processing apparatuses that are improved in terms of providing balanced flow of precursor gas(es) in between the plurality of substrates. More specifically, it is an object to provide improvement in terms of process yield and to enable uniform processing characteristics over each substrate of the plurality of substrates. To at least partially achieve this goal, the present disclosure may provide a semiconductor processing apparatus as defined in the independent claim. Further embodiments of the semiconductor processing apparatus are provided in the dependent claims.

The present disclosure relates to a semiconductor processing apparatus for processing a plurality of substrates. The apparatus may comprise a reaction chamber. The reaction chamber may comprise a reaction space for receiving a substrate boat constructed and arranged for holding the plurality of substrates. The reaction chamber may further comprise a gas distributor for providing gas into the reaction space and a gas exhaust for removing gas from the reaction space. The boat, the gas distributor and the gas exhaust may be constructed and arranged to at least partially enclose the substrates in the boat and to form a flow path, in use, from the gas distributor to the gas exhaust, wherein the gas flow path may substantially be directed in between the substrates.

The inventive semiconductor processing apparatus according to the present disclosure may allow for enabling improved flow of process gas across the reaction space compared to the flow of process gas longitudinally in the reaction space, thereby enabling horizontal flow. Furthermore, it may allow for improving the process gas flow in between the plurality of substrates arranged in the substrate boat, thereby enabling cross-flow. The semiconductor processing apparatus according to embodiments of the present disclosure may thus, provide the advantage of allowing each substrate of the plurality of substrates arranged in the substrate boat to receive the process gas uniformly over its surface for the processing.

It may thus, be an advantage of embodiments of the present disclosure that process performance may be improved. This may then advantageously lead to improved uniformity across the surface of each of the substrates. It may also advantageously lead to improved step coverage.

It may further be an advantage of embodiments of the present disclosure that the ratio of process gas utilization versus process gas provision may be improved thanks to enabling cross-flow This may then advantageously allow for efficient utilization of precursors, improved materials properties of the layer formed and improved conformality in high surface area structures.

It may therefore, be an advantage of embodiments of the present disclosure that manufacturing of memory devices, particularly the ones comprising the high surface area structures, such as DRAM and VNAND, may be improved.

It may further be an advantage of embodiments of the present disclosure that process throughput may be increased. This may further be advantageous in improving the overall manufacturing throughput.

### BRIEF DESCRIPTION OF THE DRAWING FIGURES

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure. Like reference numbers will be used for like elements in the drawings unless stated otherwise.
Fig. 1: is a schematic top view of a semiconductor processing apparatus in accordance with embodiments of the present disclosure.
Fig. 2a - Fig. 2c : is a schematic top view of a semiconductor processing apparatus with different configurations of the inlet gas manifold/exhaust gas manifold of the semiconductor processing apparatus in accordance with embodiments of the present disclosure.
Fig. 3a - Fig. 3b : is a schematic front view of an inlet gas manifold/exhaust gas manifold of the semiconductor processing apparatus comprising the openings in accordance with embodiments of the present disclosure.
Fig. 4a and Fig. 4b : is a schematic front view of mid-piece inlet gas manifold sections used in the manufacturing of the semiconductor processing apparatus in accordance with embodiments of present disclosure.
Fig. 5a - Fig. 5c : is a schematic top view of a semiconductor processing apparatus comprising baffles configured differently in accordance with embodiments of the present disclosure.
Fig. 6a and Fig. 6b: is a schematic top view of a semiconductor processing apparatus with a gas distributor and a gas exhaust conduit in accordance with embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and sub-combinations of the various processes, systems, and configurations, and other features, functions, acts, and/or properties disclosed herein, as well as any and all equivalents thereof.

The terms first, second, third and the like appearing in the description and the claims, are not used necessarily for describing an order or a sequence in any manner. On the contrary, they are meant to differentiate between similar elements or similar features.

It is to be noticed that the term "comprising", as used herein, should not be interpreted as being restricted to the means listed thereafter. It does not exclude other elements or steps. Thus, it does not prevent one or more other steps, components, or features, or groups thereof from being present or being added. It is to be interpreted as specifying the presence of the stated features, steps or components as referred to.

Reference throughout the specification to "embodiments" in various places are not necessarily all referring to the same embodiment, but may. Furthermore, the particular features, structures or characteristics maybe combined in any suitable manner, as would be apparent to one of the ordinary skill in the art from the disclosure, in one or more embodiments.

Reference throughout the specification to "some embodiments" means that a particular structure, feature step described in connection with these embodiments is included in some of the embodiments of the present invention. Thus, phrases appearing such as "in some embodiments" in different places throughout the specification are not necessarily referring to the same collection of embodiments, but may.

It is to be noticed that the term "comprise substantially" used in the claims refers that further components than those specifically mentioned can, but not necessarily have to, be present, namely those not materially affecting the essential characteristics of the material, compound, or composition referred to.

Some embodiments described herein include some but not other features included in other embodiments. However, combinations of features of different embodiments are meant to be within the scope of the disclosure, and form different embodiments, as would be understood by those in the art.

As used herein and unless provided otherwise, the term *"uniformity"* may refer to having a minimized variation of a thickness of a layer formed on the plurality of substrates.

As used herein and unless provided otherwise, the term *"horizontal flow"* may refer to the situation, such as for example in a vertical furnace, where the process gas is flowing majorly across the reaction space rather than flowing longitudinally in the reaction space, whereby the process gas flows parallel to the surface of each of the plurality of substrates.

As used herein and unless provided otherwise, the term *"cross-flow"* may refer to the situation, such as for example in a vertical furnace, where the process gas is flowing majorly in between the substrates rather than flowing around the substrates, whereby the process gas flows parallel to the surface of each of the plurality of substrates.

As used herein and unless provided otherwise, the term *"vertical furnace"* may refer to a semiconductor processing apparatus extending longitudinally in a vertical direction and being able to process a plurality of substrates provided in a substrate boat at a time.

As used herein and unless provided otherwise, the term *"substrate"* may refer to any underlying material or materials that may be used, or upon which, a device, a circuit, or a film may be formed.

As used herein and unless provided otherwise, the term *"step coverage"* may refer to the ratio of film thickness at a bottom of a feature to that on its top surface, the feature being protruding from the surface of a substrate or being formed within the substrate, such as for example, a gap or a trench.

As used herein and unless provided otherwise, the term *"gas flow path being substantially directed in between the substrates"* may refer to the gas flow to be mostly occurring through the spacing in between the substrates.

The disclosure will now be described by a detailed description of several embodiments of the disclosure. It is clear that other embodiments of the disclosure can be configured according to the knowledge of persons skilled in the art in the absence of departure from the technical teaching of the disclosure. The disclosure is limited only by the terms of the claims included herein.

The semiconductor processing apparatus (100) of the present disclosure may comprise a reaction chamber (120). In embodiments, the semiconductor processing apparatus (100) may be a vertical furnace. The reaction chamber (120) may comprise a reaction space (140) for receiving a substrate boat (170) constructed and arranged for holding the plurality of substrates (180).

The plurality of substrates (180) may, in some embodiments, be semiconductor substrates. The semiconductor substrates may, in some embodiments, be Si (111) substrates or Si (100) substrates. In some embodiments, the semiconductor substrates may be silicon nitride substrates. In some embodiments, the semiconductor substrates may be silicon carbide substrates. In some embodiments, the semiconductor substrates may be Group III-V substrates. In some embodiments, the semiconductor substrates may be Group III-N substrates. The Group III-N substrates may in some embodiments be aluminum nitride or gallium nitride substrates. In embodiments, one or more surface layers may be present or may be formed on the plurality of substrates.

In some embodiments, the plurality of substrates (180) may comprise a semiconductor layer. This semiconductor layer may, in some embodiments, be a silicon layer. The silicon layer may, in embodiments, be a Si(100) or a Si(111) layer.

The rection chamber (120) may further comprise a gas distributor (130, 210) for providing gas into the reaction space and a gas exhaust (135, 220) for removing gas from the reaction space (140).

The gas that is provided into the reaction space may, in some embodiments, be a process gas for forming a film on the plurality of substrates (180). The process gas may, in embodiments, comprise one or more precursor gases. The one or more precursors gases may be comprised in one or more reaction gas mixtures. Each reaction gas mixture may be provided to the reaction chamber by one or more deposition pulses that may be comprised in a deposition cycle. Execution of a plurality of deposition cycles may lead to the formation of the film on the surface of each substrate of the plurality of substrates.

In some embodiments, gas may refer to an inert gas. In some embodiments, the inert gas may comprise substantially one or more noble gases such as, for example, Ar, Kr, Ne, He or Xe. In some embodiments, the inert gas may comprise substantially at least one of N₂ and one or more noble gases.

The semiconductor processing apparatus (100) may, in embodiments, comprise a controller. The controller may be configured for causing the semiconductor processing apparatus to provide the one or more precursor gases into the reaction chamber, thereby enabling the formation of the film on the plurality of substrates.

The semiconductor processing apparatus may, in embodiments, comprise a gas inlet for providing the gas to the gas distributor. The gas exhaust for removing the gas from the reaction space may be connected to an exhaust gas outlet to then deliver the exhaust gas outside the semiconductor processing apparatus. The gas exhaust for removing the gas from the reaction space may be operably connected to a pump to control the pressure in the reaction chamber. The semiconductor processing apparatus may, in embodiments, further comprise a heater. The heater may be configured for heating the reaction chamber up to the required temperature to carry out the formation of the film.

The boat (170, 171) the gas distributor (130, 210) and the gas exhaust (135, 220) may be constructed and arranged to at least partially enclose the substrates (180) in the boat (170, 171) and to form a flow path, in use, from the gas distributor (130, 210) to the gas exhaust (135, 220), wherein the gas flow path may substantially be directed in between the substrates. This configuration may provide the advantage of providing cross-flow of the process gas in between the substrates when the semiconductor processing apparatus is in use. This may allow for a balanced distribution of the process gas over the surface of each substrate of the plurality of substrates (180), the surface being the one on which the film may be formed. This may thus, consequently lead to improved thickness uniformity across the surface of each of the substrates. It may also advantageously allow for obtaining improved step coverage over the surface of the substrates. Additionally, it may provide for improved utilization of the one or more precursor gases that may be comprised in the process gas. Having the flow of gas being substantially directed in between the substrates (180) may increase may allow for enhancing surface reactions, thereby minimizing precursor gas waste. Improved utilization of the one or more precursor gases may eventually lead to lowering process cost.

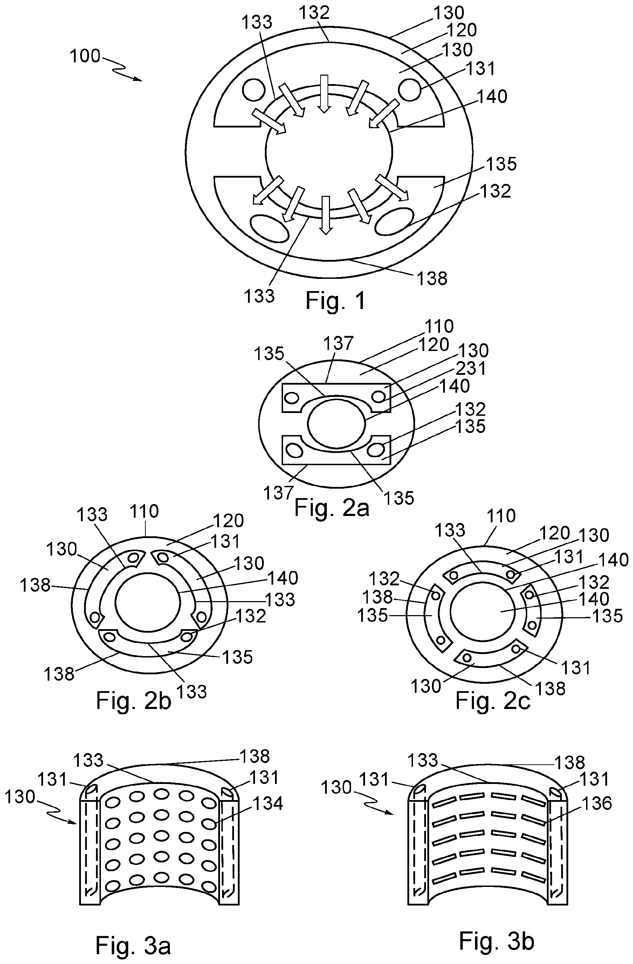

Figure 1 shows a schematic top view of a semiconductor processing apparatus for processing a plurality of substrates in accordance with embodiments of the present disclosure.

In some embodiments, the gas distributor may be an inlet gas manifold (130) for providing gas into the reaction space (140), and the gas exhaust may be an exhaust gas manifold (135) for removing gas from the reaction space (140). Each of the inlet gas manifold (130) and the exhaust gas manifold (135) may have a concave side (133). The concave side (133) may be constructed and arranged to face the substrate boat, thereby forming the reaction space (140). The inlet gas manifold (130) and the exhaust gas manifold (135) may therefore, at least partially enclose the substrates in the substrate boat. The inlet gas manifold (130) may comprise a gas inlet (not shown in Fig. 1) for providing gas to the inlet gas manifold (130) and a first set of openings to provide the gas to the reaction space (140) (provision of gas is schematically represented by the upper row of arrows) and the exhaust gas manifold (135) may comprise a gas exhaust outlet (not shown in Fig. 1) for removing the gas from the exhaust gas manifold (135) and a second set of openings for removing the gas from the reaction space (140) (removal of gas is schematically represented by the lower row of arrows), thereby forming the gas flow path, in use, from the gas inlet manifold (130) to the exhaust gas manifold (135), wherein the gas flow path may substantially be directed in between the substrates.

This may allow for obtaining cross-flow of the gas in between the substrates when the semiconductor processing apparatus is in use. This may further allow for a balanced distribution of the gas over the surface of each substrate of the plurality of substrates, the surface being the one on which the film may be formed. This may thus, consequently lead to improved thickness uniformity across the surface of each of the substrates. It may also advantageously allow for obtaining improved step coverage over the surface of the substrates.

The first and the second set of openings may therefore, be located on the concave side (133) of the inlet gas manifold (130) and the exhaust gas manifold (135).

In embodiments, each of the inlet gas manifold (130) and the exhaust gas manifold (135) may be constructed such that the concave side (133) may be faced by another concave side (138), so that the manifolds (130, 135) may have an inner concave side (133) and an outer concave side (138). This configuration may thus, allow the inlet gas manifold (130) and the exhaust gas manifold (135) to be arc-shaped. The arc-shaped manifolds may be advantageous in that they may be easier to fit in the reaction chamber (120), particularly when the semiconductor processing apparatus is a vertical furnace. As it can be easily aligned and fitted inside the process chamber (120), it provides further the advantage of maintaining the foot-print of the apparatus. In these embodiments, the first set of openings and the second set of openings may be located on the inner concave side (133) of the inlet gas manifold (130) and exhaust gas manifold (135), respectively.

The reaction chamber (120) may have a central axis and the reaction space (140) and the substrate boat may therefore, be concentric with respect to the central axis. Therefore, when the reaction chamber (120) is empty, for example when the substrate boat is not loaded into the reaction chamber(120) yet, the concave side (133) of each of the inlet gas manifold (130) and the exhaust gas manifold (135) may be facing the central axis.

When the substrate boat is loaded into the reaction chamber (120) through the reaction space (140), the substrate boat may extend along a height of the reaction chamber (120).

In embodiments, the semiconductor processing apparatus may be a vertical furnace.

In embodiments, the inlet gas manifold (130) and the exhaust gas manifold (135) may extend along a height of the reaction chamber (120), thereby, at least partially enclosing the substrates in the substrate boat.

In embodiments, the reaction chamber (120) may be bounded by a process tube (110) for forming a reactor. The process tube (110) may have a circular or a square shape.

In embodiments, each of the inlet gas manifold (130) and the exhaust gas manifold (135) may comprise at least one tube (131, 132) being operably connected to the at least one gas inlet and to the at least one gas exhaust outlet, respectively. The at least one tube (131) being operably connected to the at least one gas inlet may be constructed and arranged for distributing the gas within the inlet gas manifold (130). The at least one tube (131) may thus, be referred to as the "feed tube".

The at least one tube (132) being operably connected to the at least one gas exhaust outlet may be constructed and arranged for exhausting the gas from within the exhaust gas manifold (135). The at least one tube (132) may thus, be referred to as the "exhaust tube".

In embodiments, the feed tube (131) and the exhaust tube (132) may extend, at least partially, longitudinally along the height of the inlet gas manifold (130) or exhaust gas manifold (135). In other words, the feed tube (131) and the exhaust tube (132) may extend, at least partially, in the vertical direction along the height of the inlet gas manifold (130) or exhaust gas manifold (135). In embodiments, the feed tube (131) may comprise a gas ejection port at its distal end, thereby allowing the gas enter into the inlet gas manifold (130). It is to be understood that the distal end is located at the tip of the feed tube. In embodiments, the exhaust tube (132) may comprise a gas collection port at its distal end, thereby allowing to collect the gas in the exhaust gas manifold (135) and help it to get removed from the exhaust gas manifold (135). It is to be understood that the distal end is located at the tip of the exhaust tube.

The shape, the number and the size of the feed tube and the exhaust tube may, in some embodiments, be the same. In some embodiments the shape, the number and the size of the feed tube and the exhaust tube may be different. This may depend on the type of the process to be carried out in the apparatus. Thus, it may depend at least on the process temperature, process pressure, the type of the precursor gas and partial pressure of the precursor gas.

Having a plurality of feed tubes (131) in the inlet gas manifold (130) may allow for balanced exposure of the substrate surface to the gas, the gas being the incoming gas comprising one or more precursors. Besides, this exposure may be accomplished in a shorter period of time. For processes, such as for example, where multiple precursors need to be used and where these precursors need to be provided into the reaction space (140) simultaneously, in other words referred to as being "co-flow provision", then using more than one feed tube in the inlet gas manifold (130) may be advantageous.

Having a plurality of exhaust tubes (132) in the exhaust gas manifold (135) may allow for a quicker exhausting of the reaction space (140), by removal of the gas, the gas comprising reaction products, by-products or unreacted precursor gas. This may be particularly advantageous if a higher amount of reaction products or by-products are expected to be produced. Furthermore, having a plurality of exhaust tubes (132) in the exhaust gas manifold (135) may further help to reduce the residence time of the precursor in the reaction chamber (120). Thus, having more than one exhaust tube in the exhaust gas manifold (135) may also allow for improving process throughput.

The positioning of the plurality of feed tubes (131) in the inlet gas manifold (130) and the plurality of exhaust tubes (132) in the exhaust gas manifold (135) may, in embodiments, be arranged to allow for optimized distribution of the gas within the inlet gas manifold (130) and optimized removal of gas from the exhaust gas manifold (135), respectively. In embodiments, each of the plurality of feed tubes (131) in the inlet gas manifold (130) and each of the plurality of exhaust tubes (132) in the exhaust gas manifold (135), respectively, may be under angle between 30 ° to 180 ° with each other.

The shape and the size of the feed tube and the exhaust tube, on the other hand, may be configured to tune the fluid dynamics of the precursor(s) and fluid dynamics of the reaction products or by-products. In some embodiments, the shape of the feed tube and the exhaust tube may be cylindrical.

Fig. 2a - Fig. 2c : is a schematic top view of a semiconductor processing apparatus with different configurations of the inlet gas manifold (130) or exhaust gas manifold (135) in accordance with embodiments of the of the present disclosure. As schematically represented in these figures, the number of the inlet gas manifold (130) and the number of exhaust gas manifold (135) in the reaction chamber (120) may differ. It may be advantageous to tune the number and configuration of the inlet gas manifold (130) and the exhaust gas manifold (135) depending on the process to be carried out in the apparatus.

In some embodiments, as represented schematically in Fig. 2a, each of the inlet gas manifold (130) and the exhaust gas manifold (135) may be constructed such that the concave side (133) may be faced by a straight side (137). As seen in this schematic drawing, there is a single inlet gas manifold (130) and a single exhaust gas manifold (135) forming the reaction space (140). It is to be understood that the number of each of the inlet gas manifold (130) and exhaust gas manifold (135) as schematized in Fig. 2a may, in some embodiments, be more than 1. In an exemplary embodiment, there may be two inlet gas manifolds and two exhaust gas manifolds that may, preferably, be positioned perpendicular to one another in the reaction chamber (120). In this exemplary embodiment, each of the two inlet gas manifolds (130) and each of the two exhaust gas manifolds (135), respectively, may be positioned facing one another across the reaction space (140).

In some embodiments, as represented schematically in Fig. 2b and Fig. 2c, the total number of arc-shaped manifolds may be more than two.

Fig. 2b represents schematically two inlet gas manifolds (130) and a single exhaust gas manifold (135) in the reaction chamber (120). This configuration may be advantageous such as for example when two precursors are to be used so that one of the inlet gas manifolds may be dedicated for providing a first precursor gas into the reaction space (140) and the other inlet gas manifold may be dedicated for providing a second precursor gas into the reaction space (140). Both the first precursor gas and the second precursor gas may then be removed from the reaction space (140) by the same exhaust gas manifold (135). This configuration may be used when forming a layer by atomic layer deposition (ALD). Providing the first precursor gas and the second precursor gas to the reaction space (140) through different inlet gas manifolds may advantageously reduce the risk of coating formation on the inner surfaces of the inlet gas manifolds as the inner surfaces of the inlet gas manifolds are not coming in contact with the two precursors at any time. It is to be understood that in some embodiments, there may be a single inlet gas manifold (130) and two exhaust gas manifolds (135) (not shown in the figures). This may be advantageous in providing a faster removal of the gas from the reaction space (140).

Fig. 2c represents schematically two inlet gas manifolds (130) and two exhaust gas manifolds (135) in the reaction chamber (120) such as, for example, having a 2x2 configuration. As represented in this exemplary embodiment, the two inlet gas manifolds (130) and the two exhaust gas manifolds (135) may be facing each other across the reaction space (140). This configuration may also be advantageous such as for example when two precursors are to be used so that one of the inlet gas manifolds may be dedicated for providing the first precursor gas into the reaction space (140) and the other inlet gas manifold may be dedicated for providing the second precursor gas into the reaction space (140).

In some embodiments, the first precursor gas and the second precursor gas may be provided simultaneously to the reaction space (140), thereby providing the advantage of having the two precursors mix in the reaction space (140). The two exhaust gas manifolds (135) positioned facing each other in the reaction chamber (120) may together advantageously allow for a faster removal of reaction by-products or at least a portion of the first precursor gas and at least a portion of the second precursor gas from the reaction space (140). This configuration may also be used when forming a layer by chemical vapor deposition (CVD).

In some embodiments, the first precursor gas and the second precursor gas may be provided alternatingly to the reaction space (140) through separate inlet gas manifolds. The two exhaust gas manifolds (135) positioned facing each other in the reaction chamber (120) may together advantageously allow for a faster removal of reaction by-products or at least a portion of the first precursor gas and at least a portion of the second precursor gas from the reaction space (140). This configuration may also be used when forming a layer by atomic layer deposition (ALD).

In some embodiments, the first precursor gas may be provided to the reaction space by the one of the two inlet gas manifolds and one of the two exhaust gas manifolds may be adapted to remove the first precursor gas from the reaction space (140), while the second precursor may be provided to the reaction space (140) by the other inlet gas manifold and the other exhaust gas manifold may be adapted to remove the second precursor gas from the reaction space (140). This configuration may also be used when forming a layer by atomic layer deposition (ALD). Providing the first precursor gas and the second precursor gas to the reaction space (140) through different inlet gas manifolds and removing at least a portion of the first precursor gas and at least a portion of the second precursor gas from the reaction space (140) through different exhaust gas manifolds may advantageously reduce the risk of coating formation on the inner surfaces of the inlet gas manifolds and the exhaust gas manifolds as the inner surfaces of the manifolds are not coming in contact with the two precursors at any time.

In some embodiments, there may be three inlet gas manifolds and a single exhaust gas manifold in the reaction chamber (120). This configuration may be advantageous such as for example when three precursors are to be used so that each precursor may be provided into the reaction space (140) by each of the inlet gas manifolds (130). The removal may in this configuration, be done by the single exhaust gas manifold (135).

It is to be understood that the size of the arc-shaped manifolds may be tuned according to the process.

In some embodiments, having the 2x2 configuration, as schematically represented in Fig. 2c, the manifolds (130, 135) may be identical. In some embodiments, having the 2x2 configuration, as schematically represented in Fig. 2c, the manifolds (130, 1350 may be different in size.

In some embodiments having the 2x2 configuration, as schematically represented in Fig. 2c, the size of the inlet gas manifolds (130) may be larger than that of the exhaust gas manifolds (135). In some embodiments having the 2x2 configuration, as schematically represented in Fig. 2c, the size of the exhaust gas manifolds (135) may be larger than that of the inlet gas manifolds (130).

It is to be understood that, shape, size, alignment and number of the first set of openings and the second set of openings may be configured such that a uniform flow of gas into the space in between the substrates in the substrate boat and uniform removal of gas from in between the substrates may be obtained, thereby improving process performance. It is furthermore, to be understood that shape, size, alignment and number of the first set of openings and the second set of openings may be configured according to process to be carried out in the semiconductor processing apparatus.

Fig. 3a and Fig. 3b schematically represents the front view of the arc-shaped inlet gas manifold (130) of the semiconductor processing apparatus comprising the openings (134). The arc-shaped inlet gas manifold (130) may have the concave side (133), which may be an inner concave side, being faced by another concave side (138), which may be an outer concave side. In the schematic drawing, two feed tubes (131) are shown that may extend along the height of the manifold.

In some embodiments, as may be represented by Fig. 3a, the openings may have a round shape (134). The round shape, in some embodiments, may be substantially circular. In some embodiments, the round shape may be elliptical. In embodiments, the round-shaped openings (134) may be located across the surface area of the inner concave side (133). In some embodiments, the round-shaped openings (134) may be collinearly aligned longitudinally along the height and circumferentially on the inner concave side (133) of the inlet gas manifold as schematically represented in Fig. 3a.

In some embodiments, as may be represented by Fig. 3b, the openings may be in the shape of slits (136). In embodiments, the location and alignment of the slit-shaped openings (136) may be similar to those disclosed for the round-shaped openings (134), as schematically represented in Fig. 3a.

It is to be understood that the size of the openings (134, 136) may further be configured according to the needs of the process to be carried out in the semiconductor processing apparatus and according to the size of the manifolds.

It is further to be understood that Fig. 3a and Fig. 3b represent schematically the inlet gas manifold (130), however, similar schematic representation may also hold, in embodiments, for the exhaust gas manifold (135).

In embodiments, the openings in the first set may be constructed and adapted to correspond, at least partially, to the openings in the second set. As the concave side (133) of both the inlet gas manifold (130) and the exhaust gas manifold (135) may be constructed and arranged to face the substrate boat, the first set of openings and the second set of openings may then also face the substrate boat. Therefore, depending on the shape, the size, the alignment and the number, the first set of openings and the second set of openings may, at least partially, correspond with each other. This may allow for transport of gas across the reaction space (140). This may particularly allow for transport of gas in a cross-flow manner in between the substrates in the substrate boat across the reaction space (140).

In embodiments, the plurality of substrates may be separated from one another, in the substrate boat, by a substrate spacing. The openings in the first set may then be constructed and adapted to at least partially correspond, through the substrate spacing, to the openings in the second set. This may provide the advantage of having a uniform flow of gas into the space in between the substrates in the substrate boat and a uniform removal of gas from in between the substrates. This may allow for obtaining a flow of gas sweeping the spacing, thereby providing improvement in process performance. This may be advantageous in improving the process performance in terms of uniformity such that a thickness of the layer formed on the substrate may be substantially the same across its surface. Furthermore, it may allow for improving conformality and step coverage of particularly high surface area structures.

In some embodiments, the openings in the first set may be constructed and adapted to correspond directly through the substrate spacing, to the openings in the second set. In some embodiments, one or more rows of openings in the first set may be constructed and adapted to correspond, through the substrate spacing, to one or more rows of openings in the second set. It is to be understood that the number of rows of openings corresponding through the spacing may be constructed and arranged depending on the process. For reactions that are not limited by diffusion, it may be such that more than one row of openings in the first set may be corresponding to more than one row of openings in the second set through the spacing.

In embodiments, the spacing, in the substrate boat, between each of the substrates may be in a range from 5 mm to 30 mm. In some embodiments, the spacing may be from 10 mm to 20 mm.

Thus, in embodiments, where openings in the first set may be constructed and adapted to at least partially correspond, through the substrate spacing, to the openings in the second set, the pitch (p) of the first set of openings and the second set of openings in a vertical direction, i.e. in a direction parallel to the central axis, may thus, be expressed as 5 mm < p < 30 mm. In some embodiments, the pitch in the vertical direction may be expressed as 10 mm < p < 20 mm. In embodiments, the pitch of the first set of openings and the second set of openings on the circumferential axis of the concave side (133) may be the same as the pitch in the vertical direction.

In embodiments, each of the inlet gas manifold (130) and the exhaust manifold (135) may be formed by joining mid-piece manifold sections (130 - a, 135 - a, 130 - b, 135 - b) and two end manifold sections. The two end manifold sections may make up for the uppermost and for the lowermost portion of the inlet gas manifold (130) and the exhaust gas manifold (135).

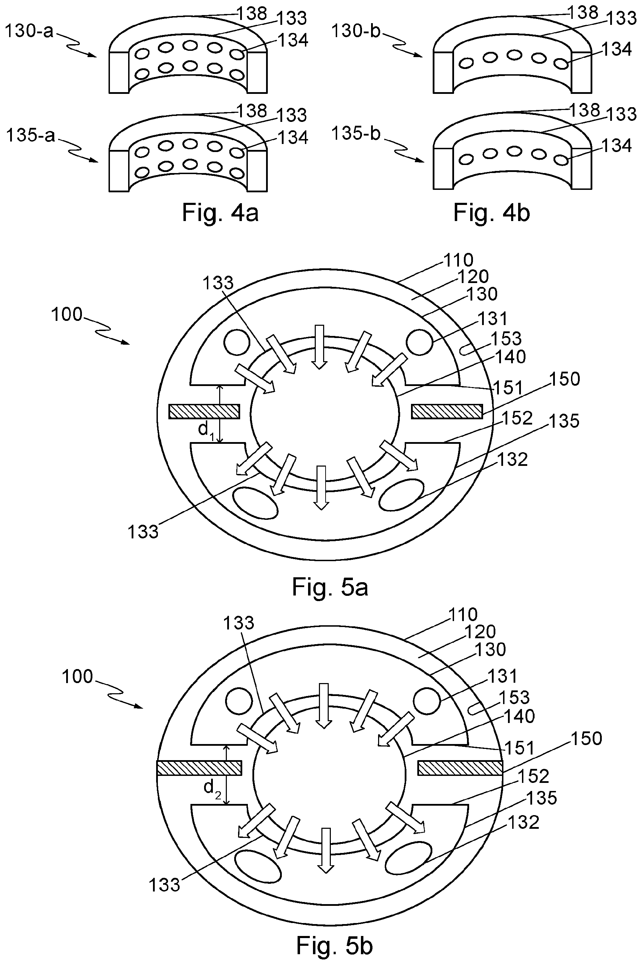

We now refer to Fig. 4a and Fig. 4b representing a schematic front view of mid-piece inlet gas manifold sections (130 - a, 130 - b) and mid-piece exhaust gas manifold sections (135 - a, 135 - b) that may be used in the manufacturing of the semiconductor processing apparatus in accordance with embodiments of the present disclosure.

Fig. 4a represents schematically a front view of a single mid-piece inlet gas manifold section (130 - a) and a single mid-piece exhaust gas manifold section (135 - a), whereby each piece comprises two rows openings (134).

Fig. 4b represents schematically a front view of a single mid-piece inlet gas manifold section (130 - b) and a single mid-piece exhaust gas manifold section (135 - b), whereby each piece comprises a single row of openings (134).

Each of the mid-piece manifold sections (130 - a, 135 - a, 130 - b, 135 - b) may, in embodiments, be constructed and arranged such that each of the mid-piece sections (130 - a, 135 - a, 130 - b, 135 - b) corresponds to each of the spacings between each of the substrates arranged in the substrate boat. This may allow for uniform provision of gas, into the reaction space (140) over the surface of the substrates, on which deposition takes place, and consequently, uniform removal of the gas, from the reaction space (140) from the surface of the substrates.

Thus, in some embodiments, each of the mid-piece manifold sections of the inlet gas manifold (130) and the exhaust manifold (135) may comprise, respectively, a row of the first set of openings and a row of the second set of openings, each of the openings in respective rows being configured and arranged to correspond to each other, at least partially, through the substrate spacing. This may allow for obtaining a flow of gas sweeping the spacing, thereby providing improvement in process performance. Improvement in process performance may be envisioned in terms of improvement in uniformity such that a thickness of the layer formed on the substrate is substantially the same across its surface. Furthermore, it may allow for improving conformality and step coverage of particularly high surface area structures.

In some embodiments, each of the inlet gas manifold (130) and the exhaust gas manifold (135) may be formed by a single manifold piece. In these embodiments, the at least one gas inlet and the at least one gas exhaust outlet may be operably connected to the inlet gas manifold (130) and to the exhaust gas manifold (135) from at least one of its lower end and its upper end. This may provide the advantage of directing the gas directly into the inlet gas manifold and removing the gas directly from the exhaust gas manifold without the need for having the feed tube (131) or the exhaust tube (132).

Each of the at least one gas inlet and the at least one gas exhaust outlet may, in some embodiments, be operably connected to the inlet gas manifold (130) and to the exhaust gas manifold (135) from its lower portion, respectively.

Each of the at least one gas inlet and the at least one gas exhaust outlet may, in some embodiments, be operably connected to the inlet gas manifold (130) and to the exhaust gas manifold (135) from its upper portion, respectively.

Each of the at least one gas inlet and the at least one gas exhaust outlet may, in some embodiments, be operably connected to the inlet gas manifold (130) and to the exhaust gas manifold (135) from opposite portions, respectively.

The first and the second set of openings (134) comprised, respectively, in the inlet gas manifold (130) and in the exhaust gas manifold (135) may have varying sizes along the height of the inlet gas manifold (130) and the exhaust gas manifold (135). This may be advantageous in case there is precursor depletion or creation of reaction products and/or by-products along the height of these manifolds (130, 135).

In embodiments, where the at least one gas inlet may be operably connected to the inlet gas manifold (130) from its lower part, this may be advantageous to compensate for the pressure difference along the height of the inlet gas manifold (130). This may be due to the presence of higher pressure at the lower portion compared to the upper portion of the inlet gas manifold (130). Therefore, the openings (134) comprised in the inlet gas manifold (130) may have a smaller size at the lower portion of the inlet gas manifold, which gradually may increase extending longitudinally to its upper portion along its height.

In embodiments, where the at least one gas outlet may be operably connected to the exhaust gas manifold (135) from its upper part, this may be advantageous to compensate for the pressure difference along the height of the exhaust gas manifold (135). Therefore, the openings (134) comprised in the exhaust gas manifold (135) may have a smaller size at the upper portion of the exhaust gas manifold, which gradually may increase extending longitudinally to its lower portion along its height.

In embodiments, the inlet gas manifold (130), the exhaust gas manifold (135) and the at least one tube (131, 132) comprised in the inlet gas manifold (130) and in the exhaust gas manifold (135), respectively may be constructed from metal. This may allow for easy manufacturing of the manifolds.

In some embodiments, the inlet gas manifold (130), the exhaust gas manifold (135) and the at least one tube (131, 132) comprised in the inlet gas manifold (130) and in the exhaust gas manifold (135), respectively, may be constructed from metal and may be provided with a layer of a material, thereby providing etch selectivity towards an etchant suitable for in-situ cleaning.

As the number of process cycles increase in a process tool, there may be increasing amount of deposition taking place on different parts of the process tube (110) including also on the manifolds, the feed tubes (131) and the exhaust tubes (132). An in-situ cleaning is typically used to remove such deposited layers from these parts after a certain number of process cycles. The etchant chemistries used for in-situ cleaning may help to get clean the deposited layer off from these parts, however, it may also run the risk of over-etching these parts. Therefore, the provision of the layer of material may be advantageous in providing etch selectivity during in-situ cleaning.

The layer of the material for this purpose may comprise a metal oxide, a metal nitride, metal carbide or a metal boride.

In some embodiments, the semiconductor processing apparatus may further comprise baffles within the reaction chamber (120). The baffles may be advantageous in improving the flow of gas within the reaction space (140). This may provide improved contact of the precursor with the substrate surface, thereby helping to improve process yield and optimizing precursor usage.

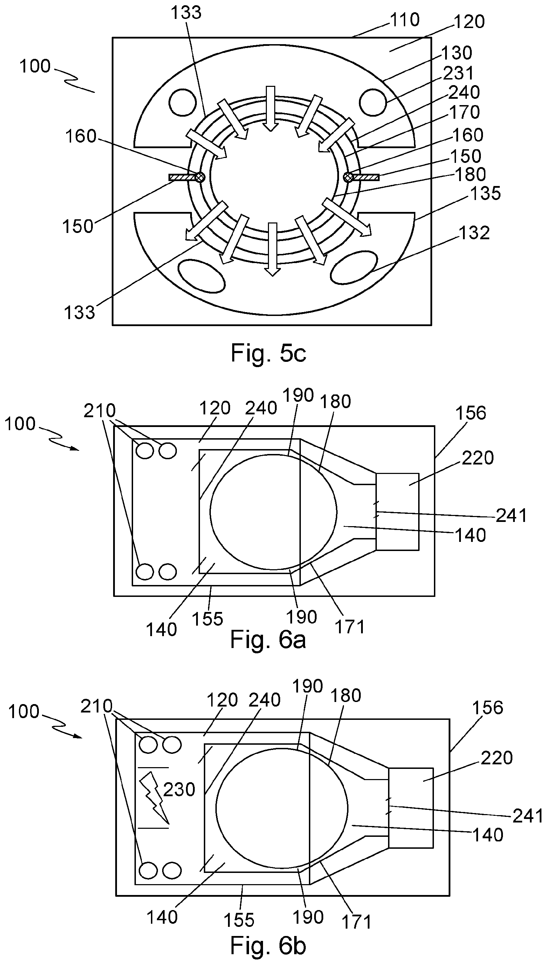

We now return to Fig. 5a, Fig. 5b and Fig. 5c each showing a schematic top view of a semiconductor processing apparatus comprising baffles.

Baffles (150) may be for use in a semiconductor processing apparatus according to embodiments of the present disclosure and they may be constructed and arranged to channel the gas, within the reaction space (140), in between each of the plurality of substrates. The baffles may therefore, provide the advantage of further aiding the creation of cross-flow within the reaction space (140) in between the substrates in the substrate boat.

In embodiments, the baffles (150) may be constructed and arranged to be positioned within a space defined in between the opposing ends (151, 152) of the inlet gas manifold (130) and the exhaust gas manifold (135) and are further constructed and arranged to extend longitudinally through the space defined. The opposing ends (151, 152) of the manifolds (130, 135) may be separated from each other by a distance (di), thereby creating the defined space between the opposing ends (151, 152) of the manifolds (130, 135). The baffles (150) may be extending longitudinally through the space defined at least along the height of the substrate boat. This may allow for channeling the gas in between each substrate of the plurality of substrates in the substrate boat. This may be advantageous in reducing the process variations between the substrates along the height of the substrate boat.

In embodiments, the baffles (150) may be positioned in between the opposing ends (151, 152) of the inlet gas manifold (130) and the exhaust gas manifold (135) symmetrically such that they may be on opposing sides of the reaction space (140).

In embodiments, the baffles (150) may be positioned equidistant from each of the opposing ends (151, 152) of the manifolds (130, 135) within the defined space. Thus, they may be positioned in the middle of the defined space (d₁).

In some embodiments, the baffles (150) may be further constructed and arranged to be attached on an inner wall (153) of the process tube (110), as schematically shown in Fig. 5b, and extending away from the inner wall (153) towards the reaction space (140). This may improve the mechanical stability for the baffles.

In some embodiments, the baffles may be further constructed and arranged to be attached to two boat rods (160), the two boat rods (160) being comprised in the substrate boat (170) and being positioned symmetrically with one another in the reaction space (140) and wherein the baffles (150) may be further constructed and arranged to extend away from the two boat rods (160) towards the defined space (Fig. 5c).

In embodiments, the baffles may be in the form of rectangular metal plates, the longer side of which being parallel to and corresponding in length, at least partially, to the opposing ends (151, 152) of the manifolds (130, 135) as schematically shown in Fig. 5a. This configuration of the baffles (150) may advantageously help in directing the flow of gas from the openings (134) of the inlet gas manifold (130) towards the reaction space (140). Furthermore, they will advantageously help to direct the gas from the reaction space (140) towards the openings (134) of the exhaust gas manifold (135). As the baffles (150) may be extending longitudinally through the reaction space (140) and along the height of the substrate boat, baffles may advantageously help in channeling the gas through the spacing in between each of the substrates arranged in the substrate boat, which is placed in the reaction space (140).

In embodiments, the process tube may be made from metal, ceramic or quartz.

In embodiments the baffles made be made of the same material as the process tube.

In embodiments, the baffles may be made from metal.

In some embodiments, the baffles may be made of metal and may be coated with a layer of a material, the layer providing etch selectivity towards an etchant suitable for in-situ cleaning. As the number of substrates being processed increase in each process cycle, different parts of the process tube including the manifolds, the feed tubes, the exhaust tubes and baffles also get coated with the layer of the film formed on the plurality of substrates. An in-situ cleaning is typically used to remove the deposited layers from these parts after a certain number of process cycles. The etchant chemistries used for in-situ cleaning may help to get rid of the deposited layer on these parts, however, these parts may run the risk of getting over-etched. Therefore, coating the baffles with a layer of material may advantageously allow for protecting the parts including the baffles from over-etching. This may provide prolonged lifetime of baffles and reduce the risk of disturbing the flow of gas in the reaction space (140) by allowing their morphology and dimensions remain intact.

The present disclosure also discloses a process for manufacturing a semiconductor processing apparatus.

The process may comprise forming a reaction chamber (120), the reaction chamber (120) may be bounded by the process tube (110). The reaction chamber (120) may comprise a reaction space (140) constructed and arranged to receive a substrate boat with the plurality of substrates. The process may further comprise providing an inlet gas manifold (130), in the reaction chamber (120), for providing gas into the reaction space (140). It may further comprise providing an exhaust gas manifold (135), in the reaction chamber (140), for removing the gas from the reaction space (140). Each of the inlet gas manifold (130) and exhaust gas manifold (135) may have a concave side constructed and arranged to face to substrate boat (170), thereby forming the reaction space (140). The inlet gas manifold (130) may comprise a gas inlet for providing gas to the inlet gas manifold (130) and a first set of openings to provide the gas to the reaction space (140). The exhaust gas manifold (135) may comprise a gas exhaust outlet for removing the gas from the exhaust gas manifold (135) and a second set of openings for removing the gas from the reaction space (140).

In embodiments, the first set of openings and the second set of openings may be located on the concave side (133) of the inlet gas manifold (130) and exhaust gas manifold (135), respectively. In some embodiments, the first and the second set of openings may have a round shape (134). The round shape, in some embodiments, may be substantially circular. In some embodiments, the round shape may be elliptical. In some embodiments, the first and the second set of openings may be in the form of slits (136).

In embodiments, the first set of openings may be constructed and adapted to correspond, at least partially, to the second set of openings. As the concave side (133) of both the inlet gas manifold (130) and the exhaust gas manifold (135) may be constructed and arranged to face the substrate boat (170), the first set of openings and the second set of openings may then also face the substrate boat (170). Therefore, depending on the shape, the size, the alignment and the number, the first set of openings and the second set of openings may, at least partially, correspond with each other. This may allow for a transport of gas through the reaction space (140) such that in-flow of gas to the reaction space (140) may be may be balanced with out-flow of gas from the reaction space (140). This may thus, provide the advantage of creating a gas flow path from the gas inlet manifold (130) to the gas exhaust manifold (135), wherein the gas flow path may substantially be directed in between the substrates (180).

The substrate boat (170) is typically arranged for holding the plurality of substrates (180). Typically the substrates (180) are separated from one another, in the substrate boat (170), by a substrate spacing. In embodiments, the spacing may be in a range from 5 mm to 30 mm. In some embodiments, the spacing may be in a range from 10 mm to 20 mm.

Thus, in some embodiments, the first set of openings may be constructed and adapted to, at least partially, correspond through the substrate spacing to the second set of openings. This may provide the advantage of having a uniform flow of gas into the space in between the substrates in the substrate boat and a uniform removal of gas from in between the substrates. This may allow for obtaining a flow of gas that may sweep the spacing. This may provide the advantage of improving process performance. The process performance may be in terms of uniformity such that a thickness of the layer formed on the substrate is substantially the same across its surface. Furthermore, it may allow for improving conformality and step coverage of particularly high surface area structures.

Thus, in embodiments, where openings in the first set may be constructed and adapted to at least partially correspond, through the substrate spacing, to the openings in the second set, the pitch (p) of the first set of openings and the second set of openings in a vertical direction, i.e. in a direction parallel to the central axis, may thus, be expressed as 5 mm < p < 30 mm.

In some embodiments, the pitch in the vertical direction may be expressed as 10 mm < p < 20 mm. In embodiments, the pitch of the first set of openings and the second set of openings on the circumferential axis of the concave side (133) may be the same as the pitch in the vertical direction or different than the pitch in the vertical direction.

In embodiments, the process may further comprise operably connecting at least one tube to the at least one gas inlet and to the at least one gas exhaust outlet, respectively, thereby distributing the gas and exhausting the gas within the inlet gas manifold (130) and within the exhaust gas manifold (135), respectively. The at least one tube (131) that may be operably connected to the gas inlet may thus, be referred to as the "feed tube

The at least one tube (132) that may be operably connected to the gas exhaust outlet may thus, be referred to as the "exhaust tube". The shape, the number and the size of the feed tube and the exhaust tube may, in some embodiments, be the same. In some embodiments the shape, the number and the size of the feed tube and the exhaust tube may be different. This may depend on the type of the process to be carried out in the apparatus.

In some embodiments, the inlet gas manifold (130) and the exhaust gas manifold (135) may be arc-shaped thereby having the concave side (133), which may be an inner concave side, being faced by another concave side (138), which may be an outer concave side as represented schematically in Fig. 3a and Fig. 3b.

In some embodiments, the inlet gas manifold (130) and the exhaust gas manifold (135) may be such that the concave side (133) may be faced by a straight side (137) as schematically represented in Fig. 2a.

In some embodiments, providing the inlet gas manifold (130) and the exhaust gas manifold (135) may comprise providing a plurality of metal or ceramic sheets. In embodiments, the metal or the ceramic sheets may be round shaped. This may advantageously allow for manufacturing the process tube (110) configured for arrangement in a vertical furnace.

In embodiments, each of the plurality of metal sheets may be machined, thereby forming, in each of the sheets, a first opening having a first concave side facing a second opening having second concave side, the first opening being separated from the second opening by a third opening being substantially circular, and wherein the first concave side and the second concave side may comprise a row of first set of openings and a row of second set of openings, respectively. Machining the plurality of metal sheets may, in embodiments, be done by computer numerical control (CNC) machining.

The provision of the manifolds, in these embodiments, may further comprise stacking the machined sheets on one another.

The machined plates may, in some embodiments, contain holes and pins for alignment.

The machined sheets may, in some embodiments, be bolted together. This may provide the advantage of leading to improved sealing between the machined sheets. In these embodiments, O-rings may be used in order to further improve the sealing.

The provision of manifolds may, in these embodiments, further comprise joining the stacked machined sheets with one another, thereby forming the inlet gas manifold (130) that may comprise the first set of openings and the exhaust gas manifold (135) that may comprise the second set of openings. In embodiments, where plurality of metal sheets are provided, joining the stacked machined sheets may be done by welding. The manifolds may be separated from each other by the substantially circular reaction space (140) for receiving the substrate boat (170) with the plurality of substrates (180).

In some embodiments, providing the inlet gas manifold (130) and the exhaust gas manifold (135) may comprise forming a plurality of mid-piece manifold sections. Each of the mid-piece manifold sections of the inlet gas manifold(130) and the exhaust manifold (135) may have a concave side and may comprise, respectively, a row of the first set of openings and a row of the second set of openings on the concave side. The provision of the inlet gas manifold (130) and the exhaust gas manifold (135) may further comprise forming two end-manifold sections each having a concave side.

Furthermore, the sections may be joined together, thereby forming the inlet gas manifold (130), that may comprise the first set of openings and the exhaust gas manifold (135) that may comprise the second set of openings and the manifolds may be separated from each other by the reaction space (140) for receiving the substrate boat with the plurality of substrates.

It may be advantageous to form the manifolds as described in these embodiments since the dimensions of each of the manifold pieces may be configured such that each piece may correspond to the substrate spacing in the substrate boat (170) so that, through the row of openings that may be comprised in the concave side (133) of each of the pieces, a gas flow path from the gas inlet manifold (130) to the gas exhaust manifold (135) may be obtained through the substrate spacing In between the substrates (180).

We now return to Fig. 6a and Fig. 6b showing a schematic top view of a semiconductor processing apparatus (100) with a gas distributor and a gas exhaust conduit in accordance with embodiments of the present disclosure.

In embodiments, the gas distributor may be a gas injector (210) for providing gas into the reaction space (140) and the gas exhaust may be a gas exhaust conduit (220) for removing gas from the reaction space (140). Each of the gas injector (210) and the exhaust conduit (220) may be constructed and arranged to face the substrate boat (171), thereby forming the reaction space (140). The reaction chamber (120) may be defined by outer walls (156) and may have inner walls (155) bounding the reaction chamber (120). The inner walls (155) of the reaction chamber (120) may be merging to the gas exhaust conduit (220) in such a way that the reaction chamber (120) forms a closed enclosure. The substrate boat (171) may be constructed and arranged such that an annulus around the substrates (180) may be eliminated, thereby forming a gas flow path, in use, from the gas injector (210) to the exhaust conduit (220), wherein the gas flow path may substantially be directed in between the substrates.

The annulus around the substrates that may be eliminated may, in embodiments, be on a side of the substrate boat (171) facing the gas exhaust conduit (220). The removal of the annulus may allow for channeling the gas flow path towards the gas exhaust conduit (220).

This configuration may also provide the advantage of providing cross-flow of the process gas in between the substrates (180) when the semiconductor processing apparatus (100) is in use. This may allow for a balanced distribution of the process gas over the surface of each substrate of the plurality of substrates, the surface being the one on which the film may be formed. This may thus, consequently lead to improved thickness uniformity across the surface of each of the substrates. It may also advantageously allow for obtaining improved step coverage over the surface of the substrates. Additionally, it may provide for improved utilization of the one or more precursor gases that may be comprised in the process gas, thereby minimizing precursor gas waste. Improved utilization of the one or more precursor gases may eventually lead to lowering process cost.

The gas injector (210) may extend longitudinally in the reaction chamber (120). It may extend along the height of the substrate boat (171), thereby allowing to distribute the gas to each substrate of the plurality of substrates. The gas injector (210) may, in embodiments, comprise a plurality of gas injection holes spaced apart from one another along the longitudinal axis of the gas injector.

In embodiments, the gas injector (210) may be comprised in a plurality of gas injectors for providing the gas into the reaction space (140). The gas injectors may be constructed and arranged in groups.

In embodiments, the group of gas injectors may be constructed and arranged inside the reaction chamber (120) in such a way that a lateral distribution of gas flow is obtained from the group of gas injectors (210) to the exhaust conduit (220) through the reaction space (140). In embodiments, where the gas comprises more than one precursor gas, each precursor gas may be provided by one or more gas injectors that may be grouped together.

Grouping of gas injectors (210) may be advantageous when pre-mixing of the precursor gases may be needed before contacting the surface of each substrate of the plurality of substrates (180), the surface being the one on which the film may be formed. This may be advantageous such as for example when forming a film by chemical vapor deposition (CVD). The number and the positioning of the group of gas injectors may be arranged, in these embodiments, such that improved mixing of the precursors may be obtained. The positioning of the gas injectors may comprise alignment of the gas injectors (210) with respect to each other and the distance that needs to be set in between them.

Grouping of gas injectors (210) may also be advantageous when more than precursor gas needs to be provided into the reaction space (140) in an alternating sequence, such as for example when forming a film by atomic layer deposition (ALD). Each precursor gas may be provided by one group of gas injector, thereby reducing the risk of potential film deposition inside the gas injectors as the inner surface of different groups of gas injectors are exposed to different precursor gases. This may help extending the lifetime of gas injectors and further help to reduce downtime required for cleaning.

The semiconductor processing apparatus (100) may, in embodiments thus, be a vertical furnace for performing atomic layer deposition. This may provide the advantage of improving throughput by allowing the formation of conformal films on each substrate of the plurality of substrates.

In embodiments, the semiconductor apparatus (100) may further comprise a plasma source (230) (Fig. 3b). This may allow for performing plasma enhanced atomic layer deposition on the plurality of substrates. This may therefore, advantageously open route to forming films at reduced process temperatures on the plurality of substrates and providing an improved flexibility in optimizing the gas phase components in order to obtain desired characteristics of the film formed. In an exemplary embodiment, the plasma source (230) may be advantageous such as for example for forming layers comprising a nitride. This may be due to the fact that nitrogen gas may be used for the creation of nitrogen radicals for forming the layers comprising the nitride. This may advantageously provide forming hydrogen-free nitride layers.

In some embodiments, the nitride layer may be a metal nitride.

In some embodiments, the nitride may be a silicon nitride.

In embodiments, the plasma source may be comprised in the reaction chamber (120).

The substrate boat (171) may be constructed and arranged for holding the plurality of substrates (180).

In embodiments, the substrate boat may comprise a first surface and a second surface (not shown in the figures) opposite to the first surface and at least four sides connecting the first surface to the second surface such that a first opening (240) and a second opening (241), opposite to the first opening (240) may be formed, thereby streaming the gas flow, in use, from the gas injector (210) to the exhaust conduit (220).

In embodiments, a width of the first opening (240) may be configured such that the plurality of wafers can be loaded into the substrate boat (171). The substrate boat (171) may comprise protrusions extending away from the inner walls of the at least four sides to place each substrate of the plurality of substrates inside the substrate boat (171).

In embodiments, the at least four sides may be straight sides being connected to each other in groups of two at an angle greater than 90° on opposing sides of the substrate boat such that the substrate boat may have a decreasing cross section in the direction of the gas flow from the gas injector to the gas exhaust conduit, wherein the gas flow, in use, is a convergent gas flow. The width of the first opening (240) may, in embodiments, therefore be larger than the second opening (241). The convergent flow may provide the advantage of collecting the gas flow coming from the gas injector (210) and as well as helping to channel the gas flow inside the substrate boat (171) towards the exhaust conduit (241). This may provide, advantageously, for the creation of cross-flow through the substrate boat (171).

The at least four sides being connected to each other in groups of two at an angle greater than 90° on opposing sides of the substrate boat may advantageously provide for reducing the volume of a gap (190) that may be formed at the connection point of these sides. Reduction of the volume of the gap (190) may help to reduce the gas flow path around the substrates in the substrate boat (171), compared to the gas flow path in between the substrates thereby, advantageously allowing for creating cross-flow of the gas. The angle may, in embodiments, be configured as a function of the length of the sides that are being connected in groups of two such that the volume of the gap (190) is reduced. In embodiments, where a plasma source may be comprised in the semiconductor apparatus, the substrate boat (171) may advantageously increase the probability of channeling the radicals that may be created by the plasma source into the reaction space (140). This may therefore help to enhance the surface reactions of the plasma generated radicals, thereby improving growth of the layer to be formed on the substrates.

In embodiments, the pressure in the exhaust conduit (220) may be lower than that in the reaction space (140). This may advantageously contribute to the gas flow being directed from the reaction space (140) towards the exhaust conduit (220). The pressure in the reaction chamber (120) may be in a range from vacuum pressure to above atmospheric pressure. In some embodiments, the pressure in the reaction chamber (1200 may be in a range from 0.5 Torr to 5 Torr.

In some embodiments, the gas exhaust conduit (220) may comprise an opening (241) for allowing the gas to enter from the reaction space (140) into the gas exhaust conduit (220). The opening (241) may be positioned on a side of the gas exhaust conduit (220) facing the reaction space (140). The opening (241) may extend longitudinally along a height of the gas exhaust conduit (220). In some embodiments, the gas exhaust conduit (220) may comprise a set of openings on a surface facing the substrate boat (171), thereby removing gas from the reaction space (140). The set of openings may be constructed and arranged to have a pre-determined size and pitch such that they balance the conduction of flow of gas in the exhaust gas conduit (220). The conduction of flow of gas in the exhaust gas conduit (220) may be such that a downward gas flow, in the exhaust gas conduit (220) may be higher than a combined conduction of flow of gas provided by the set of openings.

In embodiments, the exhaust gas conduit (220) may be constructed and arranged such that flow of gas is streamlined from the reaction space (140) into the gas exhaust conduit (220) and further downward in the gas exhaust conduit (220). This may advantageously allow for providing a unidirectional flow of gas, whereby the probability of back-flow or re-circulation of gas into the reaction space (140) may be reduced.

In embodiments, the reaction chamber (120) may have a rectangular or a square shape. This may help enabling the formation of the closed enclosure of the reaction chamber (120), whereby the inner walls (155) of the reaction chamber (120) may be merging to the gas exhaust conduit (220). Furthermore, it may provide the advantage of contributing to the gas flow being directed from the gas injector (210) to the gas exhaust conduit (220).

## Claims

1. A semiconductor processing apparatus for processing a plurality of substrates, comprising:
- a reaction chamber, the reaction chamber comprising:
- a reaction space, for receiving a substrate boat constructed and arranged for holding the plurality of substrates,
- a gas distributor for providing gas into the reaction space,
- a gas exhaust for removing gas from the reaction space
wherein
the boat, the gas distributor and the gas exhaust are constructed and arranged to at least partially enclose the substrates in the boat and to form a gas flow path, in use, from the gas distributor to the gas exhaust wherein the gas flow path is substantially being directed in between the substrates.

2. A semiconductor processing apparatus according to claim 1 , wherein the gas distributor is an inlet gas manifold for providing gas into the reaction space and the gas exhaust is an exhaust gas manifold for removing gas from the reaction space,
wherein
each of the inlet gas manifold and the exhaust gas manifold has a concave side constructed and arranged to face the substrate boat, thereby forming the reaction space, and;
wherein
the inlet gas manifold comprises a gas inlet for providing gas to the inlet gas manifold and a first set of openings to provide the gas to the reaction space and the exhaust gas manifold comprises a gas exhaust outlet for removing the gas from the exhaust gas manifold and a second set of openings for removing the gas from the reaction space, thereby forming the gas flow path, in use, from the gas inlet manifold to the gas exhaust manifold, wherein the gas flow path is substantially being directed in between the substrates .

3. The semiconductor processing apparatus according to claim 2, the openings in the first set are constructed and adapted to correspond, at least partially, to the openings in the second set.

4. The semiconductor processing apparatus according to claim 2 or 3, wherein the plurality of substrates are separated from one another, in the substrate boat, by a substrate spacing and wherein the openings in the first set are constructed and adapted to at least partially correspond, through the substrate spacing, to the openings in the second set.

5. The semiconductor processing apparatus according to any one of claims 2-4, wherein each of the inlet gas manifold and the exhaust gas manifold comprises at least one tube being operably connected to the at least one gas inlet and to the at least one gas exhaust outlet, respectively, and being constructed and arranged for distributing the gas and for exhausting the gas within the inlet gas manifold and from within the exhaust gas manifold, respectively.

6. The semiconductor processing apparatus according to any one of claims 2-5, wherein each of the inlet gas manifold and the exhaust manifold is formed by joining mid-piece manifold sections and two end manifold sections.

7. The semiconductor processing apparatus according to claim 6, wherein each of the mid-piece manifold sections of the inlet gas manifold and the exhaust manifold comprise, respectively, a row of the first set of openings and a row of the second set of openings, each of the openings in respective rows being configured and arranged to correspond to each other, at least partially, through the substrate spacing.

8. The semiconductor processing apparatus according to any one of claims 2-5, wherein each of the inlet gas manifold and the exhaust gas manifold is formed by a single manifold piece and wherein the at least one gas inlet and the at least one gas exhaust outlet is operably connected to the inlet gas manifold and to the exhaust gas manifold from at least one of its lower end and its upper end.

9. The semiconductor processing apparatus according to any one of claims 2-8, wherein the inlet gas manifold, the exhaust gas manifold and the at least one tube comprised in the inlet gas manifold and in the exhaust gas manifold, respectively, are constructed from metal, and are provided with a layer of a material, thereby providing etch selectivity towards an etchant suitable for in-situ cleaning.

10. The semiconductor processing apparatus according to any one of claim 2-9, the apparatus further comprising baffles within the reaction chamber.

11. Baffles for use in the semiconductor processing apparatus according to claim 10 , wherein the baffles are constructed and arranged to channel the gas, within the reaction space, in between each of the plurality of substrates.

12. Baffles according to claim 11, wherein the baffles are constructed and arranged to be positioned within a space defined in between the opposing ends of the inlet gas manifold and the exhaust gas manifold and are further constructed and arranged to extend longitudinally through the space defined.

13. A semiconductor processing apparatus according to claim 1, wherein the gas distributor is a gas injector for providing gas into the reaction space and the gas exhaust is a gas exhaust conduit for removing gas from the reaction space, and
wherein each of the gas injector and the exhaust conduit being constructed and arranged to face the substrate boat, thereby forming the reaction space, and;
wherein the substrate boat is constructed and arranged such that an annulus around the substrates is eliminated, thereby forming a gas flow path, in use, from the gas injector to the gas exhaust conduit, wherein the gas flow path is substantially being directed in between the substrates .

14. The semiconductor processing apparatus according to claim 13, wherein the substrate boat comprises a first surface, a second surface opposite to the first surface and at least four sides connecting the first surface to the second surface such that a first opening and a second opening, opposite to the first opening, are formed, thereby streaming the gas flow, in use, from the gas injector to the gas exhaust conduit.

15. The semiconductor processing apparatus according to claim 14, wherein the at least four sides are straight sides being connected to each other in groups of two at an angle greater than 90° on opposing sides of the substrate boat such that the substrate boat has a decreasing cross section in the direction of the gas flow from the gas injector to the gas exhaust conduit, wherein the gas flow, in use, is a convergent gas flow.

16. The semiconductor processing apparatus according to any one of claims 13-15, wherein pressure in the exhaust gas conduit is lower than that in the reaction space.

17. The semiconductor apparatus according to any one of claims 13-16, wherein the reaction chamber has a rectangular or square shape.
